# EUROPEAN PATENT APPLICATION

(11) **EP 4 819 799 A1**
(43) Date of publication of application: **07.10.2026**
(21) Application number: 24897090.7
(22) Date of filing: 04.10.2024
(51) Int. Cl.: H10F 39/12, H01L 23/02, H01L 23/12, H01L 23/29, H01L 23/31

(54) **SEMICONDUCTOR PACKAGE, SEMICONDUCTOR DEVICE, AND METHOD FOR MANUFACTURING SEMICONDUCTOR PACKAGE**

(30) Priority: 01.12.2023 JP 2023203579
(71) Applicant: Sony Semiconductor Solutions Corporation, Atsugi-shi, Kanagawa 243-0014 (JP)
(72) Inventor: IGARASHI, Takahiro, Atsugi-shi, Kanagawa 243-0014 (JP)
(74) Representative: MFG Patentanwälte Meyer-Wildhagen Meggle-Freund Gerhard PartG mbB
(86) International application number: PCT/JP2024/035584
(87) International publication number: WO 2025/115400

(57) **Abstract**

In a semiconductor package in which a semiconductor chip is mounted on a substrate, warpage is corrected.

The semiconductor package includes a substrate, a semiconductor chip, a member, and an underfill. In the semiconductor package, the semiconductor chip is mounted on a front surface of the substrate. The member is formed in a region surrounding a periphery of the semiconductor chip on the front surface. Furthermore, the member has a coefficient of thermal expansion that is higher than the coefficient of thermal expansion of the substrate. The underfill is injected between the substrate and the semiconductor chip, and brings the side surface thereof into contact with the member.

## Description

### TECHNICAL FIELD

The present technology relates to a semiconductor package. Specifically, the present technology relates to a semiconductor package provided with a semiconductor chip, a semiconductor device, and a method for manufacturing the semiconductor package.

### BACKGROUND ART

In recent years, a reduction in size of a semiconductor package provided with a semiconductor chip such as a high-performance computing (HPC) chip or CMOS image sensors (CIS) has been promoted. Along with a reduction in size, miniaturization of a pad or thinning of a chip is often requested, and as a result, an adverse effect increases in a case where warpage is generated in the semiconductor chip. In view of the above, there has been proposed a semiconductor package having a structure in which a stiffener having a coefficient of thermal expansion (CTE) different from that of a printed wiring board has been bonded around a semiconductor chip (see, for example, Patent Document 1).

### CITATION LIST

### PATENT DOCUMENT

Patent Document 1: Japanese Patent Application Laid-Open No. 2010-109318

### SUMMARY OF THE INVENTION

### PROBLEMS TO BE SOLVED BY THE INVENTION

In the conventional technology described above, an attempt is made to correct the warpage of the semiconductor chip by bonding the stiffener. However, by only using the stiffener, the stress acting in a direction of correcting the warpage is insufficient, and the warpage of the semiconductor chip fails to be sufficiently corrected in some cases.

The present technology has been made in view of such a situation, and an object thereof is to correct warpage in a semiconductor package in which a semiconductor chip has been mounted on a substrate.

### SOLUTIONS TO PROBLEMS

The present technology has been made to solve the problems described above, and a first aspect of the present technology is a semiconductor package including: a substrate; a semiconductor chip that is mounted on a front surface of the substrate; a member that is formed in a region surrounding a periphery of the semiconductor chip on the front surface of the substrate, the member having a coefficient of thermal expansion that is higher than the coefficient of thermal expansion of the substrate; and an underfill that is injected between the substrate and the semiconductor chip, and brings a side surface into contact with the member, and a method for manufacturing the semiconductor package. This brings about an effect of correcting the warpage of the semiconductor chip.

Furthermore, in the first aspect, the member may have a frame shape when viewed in a direction perpendicular to the substrate. This brings about an effect of restraining the underfill from spreading to the outside of the substrate.

Furthermore, in the first aspect, the member may include a plurality of elongated plates. This brings about an effect of correcting the warpage of the semiconductor chip.

Furthermore, in the first aspect, the member may be bonded to the front surface of the substrate by using a thermosetting adhesive having a glass transition temperature that is higher than a melting temperature of solder. This brings about an effect of enabling reflow and thermocompression bonding to be simultaneously performed.

Furthermore, in the first aspect, an additional chip that is mounted on the front surface of the substrate to be adjacent to the semiconductor chip may be further included. This brings about an effect of improving the performance of the semiconductor package.

Furthermore, in the first aspect, a front surface of each of the additional chip and the member may be colored. This brings about an effect of restraining reflected light on the front surfaces of the additional chip and the member.

Furthermore, in the first aspect, glass that is bonded to the front surface of each of the additional chip and the semiconductor chip by using resin may be further included. This brings about an effect of restraining stress imbalance.

Furthermore, in the first aspect, glass that is bonded to the front surface of the semiconductor chip by using resin may be further included. This brings about an effect of reducing the area of glass.

Furthermore, in the first aspect, the additional chip and the semiconductor chip may be arranged in a predetermined direction parallel to the substrate, and a width of the member in the predetermined direction may be greater on a side of the additional chip than on a side of the semiconductor chip. This brings about an effect of restraining cracking or peeling of the member.

Furthermore, in the first aspect, a cavity may be formed on the front surface of the substrate, the member may be formed in a periphery of the cavity, and the semiconductor chip may be mounted in the cavity. This brings about an effect of increasing the area of contact between the underfill and the semiconductor chip.

Furthermore, in the first aspect, the substrate may include wiring formed along an outer periphery of the substrate, and the member may be a conductive member. This brings about an effect of causing the member and the wiring to function as a capacitor.

Furthermore, in the first aspect, glass may be further included, and the semiconductor chip may perform photoelectric conversion on incident light transmitted through the glass to generate image data. This brings about an effect of capturing an image.

Furthermore, a second aspect of the present technology is a semiconductor device including: a substrate; a semiconductor chip that is mounted on a front surface of the substrate; a member that is formed in a region surrounding a periphery of the semiconductor chip on the front surface of the substrate, the member having a coefficient of thermal expansion that is higher than the coefficient of thermal expansion of the substrate; an underfill that is injected between the substrate and the semiconductor chip, and brings a side surface into contact with the member; glass that is bonded to a light receiving surface of the semiconductor chip by using resin; and a processing circuit that performs processing on data from the semiconductor chip. This brings about an effect of correcting the warpage of the semiconductor chip in the semiconductor device.

### BRIEF DESCRIPTION OF DRAWINGS

Fig. 1 is a block diagram illustrating a configuration example of a camera module according to a first embodiment of the present technology.
Fig. 2 illustrates examples of a cross-sectional view and a top view of a semiconductor package according to the first embodiment of the present technology.
Fig. 3 illustrates examples of a cross-sectional view and a top view of a semiconductor package including glass having a different size according to the first embodiment of the present technology.
Fig. 4 is a diagram illustrating an example of stress generated in the semiconductor package according to the first embodiment of the present technology.
Fig. 5 is a diagram for explaining the effect of restraining warpage according to the first embodiment of the present technology.
Fig. 6 is a diagram for explaining a method for manufacturing the semiconductor package according to the first embodiment of the present technology.
Fig. 7 is a flowchart illustrating an example of the method for manufacturing the semiconductor package according to the first embodiment of the present technology.
Fig. 8 illustrates examples of a cross-sectional view and a top view of a semiconductor package according to a second embodiment of the present technology.
Fig. 9 illustrates examples of a cross-sectional view and a top view of a semiconductor package according to a modification of the second embodiment of the present technology.
Fig. 10 is a diagram for explaining a manufacturing method up to application of an underfill according to the modification of the second embodiment of the present technology.
Fig. 11 is a diagram for explaining a manufacturing method up to coloring according to the modification of the second embodiment of the present technology.
Fig. 12 illustrates examples of a cross-sectional view and a top view of a semiconductor package according to a third embodiment of the present technology.
Fig. 13 illustrates examples of a cross-sectional view and a top view of a semiconductor package according to a fourth embodiment of the present technology.
Fig. 14 illustrates examples of a cross-sectional view and a top view of a semiconductor package according to a fifth embodiment of the present technology.
Fig. 15 illustrates examples of a cross-sectional view and a top view of a semiconductor package according to a sixth embodiment of the present technology.
Fig. 16 illustrates examples of a cross-sectional view and a top view of a semiconductor package according to a seventh embodiment of the present technology.
Fig. 17 illustrates an example of a cross-sectional view taken when cutting a mounting substrate according to the seventh embodiment of the present technology along a plane parallel to a substrate plane.
Fig. 18 is a block diagram illustrating a configuration example of the semiconductor package according to the seventh embodiment of the present technology.
Fig. 19 is a block diagram illustrating an example of a schematic configuration of a vehicle control system.
Fig. 20 is an explanatory diagram illustrating an example of installation positions of an outside-vehicle information detecting section and an imaging section.

### MODE FOR CARRYING OUT THE INVENTION

Modes for carrying out the present technology (hereinafter referred to as embodiments) will be described below. The description will be given in the following order.
1. First Embodiment (Example of Correcting Warpage by Using Member and Underfill)
2. Second Embodiment (Example of Adding Chip and Correcting Warpage by Using Member and Underfill)
3. Third Embodiment (Example of Adding Chip and Correcting Warpage by Using Member Having Adjusted Width and Underfill)
4. Fourth Embodiment (Example of Correcting Warpage by Using Member and Underfill in Cavity Structure)
5. Fifth Embodiment (Example of Adding Chip, Increasing Area of Glass, and Correcting Warpage by Using Member and Underfill)
6. Sixth Embodiment (Example of Correcting Warpage by Using Discontinuous Member and Underfill)
7. Seventh Embodiment (Example of Correcting Warpage by Using Member Bonded to Wiring and Underfill)
8. Example of Application to Mobile Body

### <1. First Embodiment>

### [Configuration Example of Camera Module]

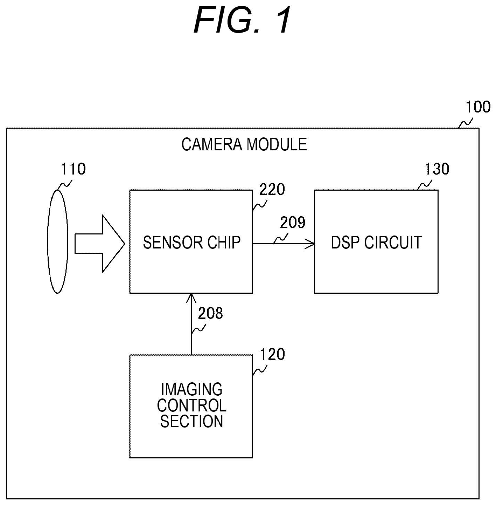

Fig. 1 is a block diagram illustrating a configuration example of a camera module 100 according to a first embodiment of the present technology. The camera module 100 is a module that captures image data, and includes an optical section 110, a sensor chip 220, an imaging control section 120, and a digital signal processing (DSP) circuit 130. Note that the camera module 100 is an example of a semiconductor device described in the claims.

The optical section 110 condenses incident light and guides the incident light to the sensor chip 220. The sensor chip 220 has, for example, a function of a CIS, and performs photoelectric conversion to generate image data. The image data is supplied to the DSP circuit 130 via a signal line 209. Note that the sensor chip 220 is an example of a semiconductor chip described in the claims.

The imaging control section 120 controls an imaging operation of the sensor chip 220. The imaging control section 120 supplies various kinds of signals, such as a vertical synchronizing signal, to the sensor chip 220 via a signal line 208.

The DSP circuit 130 performs various types of processing on image data from the sensor chip 220. Note that the DSP circuit 130 is an example of a processing circuit described in the claims.

In the camera module 100 illustrated in the drawing, the sensor chip 220 is disposed in the semiconductor package described later.

### [Configuration Example of Semiconductor Package]

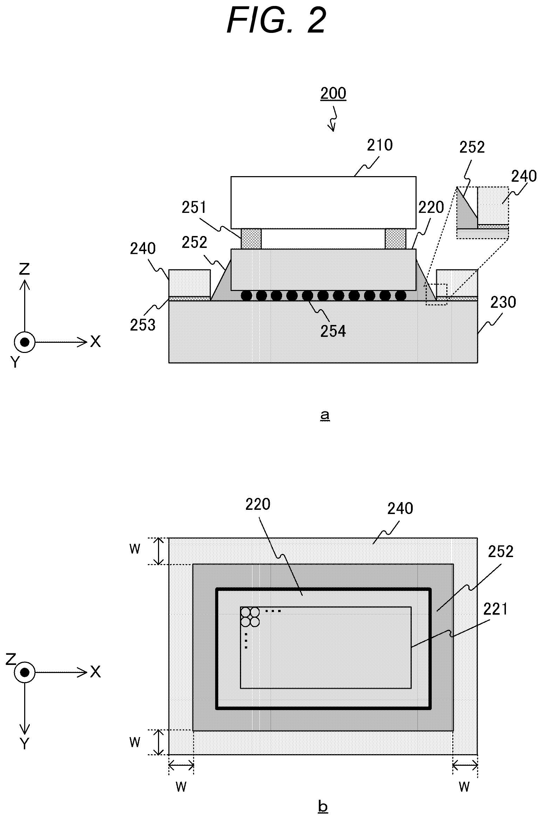

Fig. 2 illustrates examples of a cross-sectional view and a top view of a semiconductor package 200 according to the first embodiment of the present technology. In the drawing, a is the cross-sectional view of the semiconductor package 200, and b of the drawing is the top view of the semiconductor package 200.

As illustrated in a of the drawing, the semiconductor package 200 includes glass 210, the sensor chip 220, a mounting substrate 230, and a member 240.

The mounting substrate 230 is a substrate configured to mount the sensor chip 220 or the like, and an organic substrate or the like is used as the mounting substrate 230. It is assumed that the area of the mounting substrate 230 is larger than the area of the sensor chip 220. Note that the mounting substrate 230 is an example of a substrate described in the claims.

Hereinafter, it is assumed that an axis perpendicular to a substrate surface of the mounting substrate 230 is a "Z axis". It is also assumed that a predetermined axis parallel to the substrate surface of the mounting substrate 230 is an "X axis". It is assumed that an axis perpendicular to the X axis and the Z axis is a "Y axis". In the drawing, a is a cross-sectional view when viewed in a Y-axis direction.

Both surfaces of the mounting substrate 230 are flat, and in a predetermined region of one of both surfaces, the sensor chip 220 is mounted by using solder balls 254. The sensor chip 220 performs photoelectric conversion on incident light transmitted through the glass 210 to generate image data.

Here, it is assumed that the coefficient of thermal expansion (CTE) of the sensor chip 220 is lower than the coefficient of thermal expansion of the mounting substrate 230. Furthermore, the sensor chip 220 may be a chip of a single semiconductor substrate, or may be a chip having a stacked structure in which a plurality of semiconductor substrates has been stacked. In the case of a stacked structure of two layers, for example, a substrate on which pixels are arranged is disposed on an upper side, and a substrate on which a logic circuit is disposed is disposed on a lower side. In the case of a stacked structure of three or more layers, a substrate on which a memory is disposed, or the like is further inserted.

The stacking technology enables upper and lower pads to be connected at a narrow pitch, and therefore the stacking technology can be developed for various purposes, but as the logic generation progresses, variations in characteristics of a transistor become remarkable, and the degree of difficulty increases.

Hereinafter, it is assumed that in a Z-axis direction, a direction from the mounting substrate 230 toward the sensor chip 220 is an "upward" direction. It is assumed that an upper surface of the glass 210, the sensor chip 220, or the mounting substrate 230 is a "front surface", and a lower surface is a "reverse surface".

Furthermore, a member 240 is bonded to a region surrounding the periphery of the sensor chip 220 of the front surface of the mounting substrate 230, by using a thermosetting adhesive 253. It is assumed that the coefficient of thermal expansion (CTE) of the member 240 is higher than the coefficient of thermal expansion of the mounting substrate 230, and the elastic modulus of the member 240 is higher than the elastic modulus of the mounting substrate 230. Furthermore, as the member 240, a conductive member can be used. Furthermore, it is preferable that the glass transition temperature of the thermosetting adhesive 253 be higher than the melting temperature of solder.

Furthermore, an underfill 252 is injected between the sensor chip 220 and the mounting substrate 230. As illustrated in an enlarged view on an upper right side, a side surface of the underfill 252 is in contact with the member 240.

Furthermore, the glass 210 is bonded to the front surface (in other words, a light receiving surface) of the sensor chip 220 by using resin 251. The glass 210 is also called cover glass or sealing glass. It is assumed that the coefficient of thermal expansion (CTE) of the glass 210 is higher than that of silicon included in the sensor chip 220.

As illustrated in b of the drawing, the shape of the member 240 is a frame shape surrounding the sensor chip 220, when viewed from above. Furthermore, the width W of the member 240 has the same value in each of the X-axis direction and the Y-axis direction.

A thick frame in b of the drawing indicates the outer periphery of the glass 210. On the front surface of the sensor chip 220, a pixel array 221 in which a plurality of pixels has been arranged is formed. Note that in b of the drawing, the resin 251 is omitted. The similar applies to the top views described below.

The coefficient of thermal expansion of the sensor chip 220 is lower than that of the mounting substrate 230, and therefore a difference in the coefficient of thermal expansion causes stress to be generated in a direction in which the sensor chip 220 warps in a convex shape at the time of contraction after heating. The direction of warping in a convex shape is also called a cry direction.

On the other hand, the coefficient of thermal expansion of the glass 210 is higher than that of the sensor chip 220, and therefore a difference in the coefficient of thermal expansion causes stress to be generated in a direction in which the sensor chip 220 warps in a concave shape at the time of contraction after heating. The direction of warping in a concave shape is also called a smile direction. It is assumed that warpage in the cry direction fails to be sufficiently corrected by only using the glass 210.

The coefficient of thermal expansion of the member 240 is higher than that of the mounting substrate 230, and therefore a difference in the coefficient of thermal expansion causes stress to be generated in the smile direction at the time of contraction after heating. Moreover, the side surface of the underfill 252 is in contact with the member 240, and therefore stress is generated in the smile direction due to the curing shrinkage of the underfill 252. Due to the stress in the smile direction that has been caused by the member 240 and the underfill 252, it is possible to sufficiently correct warpage in the cry direction that could not be corrected by only using the glass 210. By correcting the warpage, stress put on the solder balls 254 can be reduced.

Furthermore, the member 240 has a frame shape, and therefore the member 240 also functions as a dam that stops the underfill 252 from spreading to the outside of the substrate.

Note that a semiconductor chip disposed in the semiconductor package 200 is not limited to the sensor chip 220 having a function of a CIS. For example, a logic chip or a memory chip can be disposed instead of the sensor chip 220, and the warpage thereof can be corrected by using the member 240 or the like. In this case, the glass 210 can be reduced.

For example, an HPC-based chip can be provided instead of the sensor chip 220. In the HPC-based chip, the miniaturization of a pad is often promoted and secondary mounting is considered, and therefore the warpage of a substrate attracts attention, but the warpage of the chip is not much focused. In a case where secondary mounting is performed, the diameter of solder increases, and therefore more microscopic adjustment is requested. In the HPC-based chip, mounting is performed by performing thermal compression bonding (TCB), and therefore a process considering a difference in the coefficient of thermal expansion between the semiconductor chip and the substrate is used. In a case where such a process technology is applied to a CIS, an on chip lens (OCL) is present, and therefore it is suitable to use reflow at the time of mounting. Details of a manufacturing process will be described later.

The structure illustrated in a and b of the drawing is suitable for a reduction in size, because the glass 210 is directly mounted on the light receiving surface of the sensor chip 220. However, in thinning the sensor chip 220, it is necessary to restrain mechanical damage to the sensor chip 220. Therefore, the warpage of the sensor chip 220 is corrected by using the member 240 having a high coefficient of thermal expansion and the underfill 252 in which a side surface is in contact with the member 240.

Note that the area of the glass 210 is the same as that of the sensor chip 220, but this configuration is not restrictive.

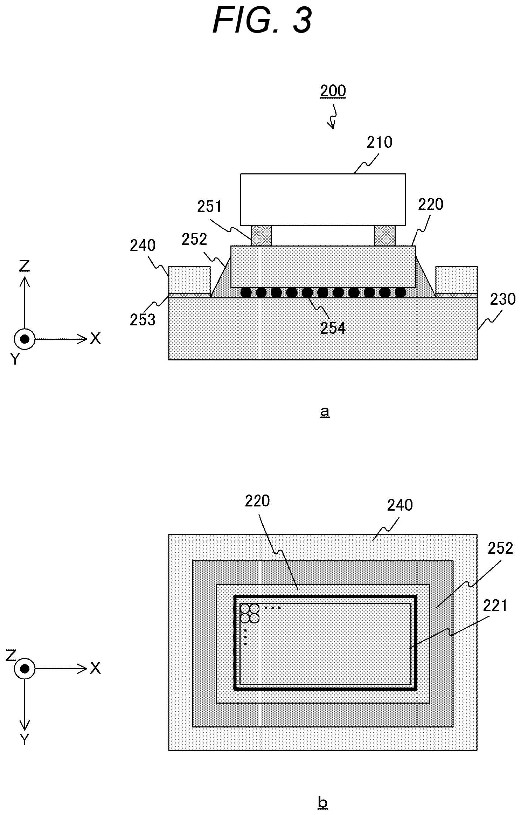

As illustrated in a and b of Fig. 3, the area of the glass 210 can be made smaller than that of the sensor chip 220. A thick frame in b of the drawing indicates the outer periphery of the glass 210. As illustrated in b of the drawing, the area of the glass 210 can be made smaller than that of the sensor chip 220 as long as the pixel array 221 can be covered.

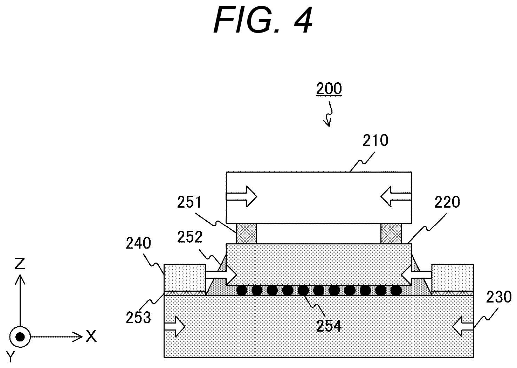

Fig. 4 is a diagram illustrating an example of stress generated in the semiconductor package 200 according to the first embodiment of the present technology. An arrow in the drawing indicates a direction of stress.

As illustrated in the drawing, the coefficient of thermal expansion of the glass 210 is higher than that of the sensor chip 220, and therefore stress is generated in a direction in which the sensor chip 220 warps in a concave shape (that is, the smile direction). Furthermore, the coefficient of thermal expansion of the member 240 is higher than that of the mounting substrate 230, and therefore stress is generated in the smile direction.

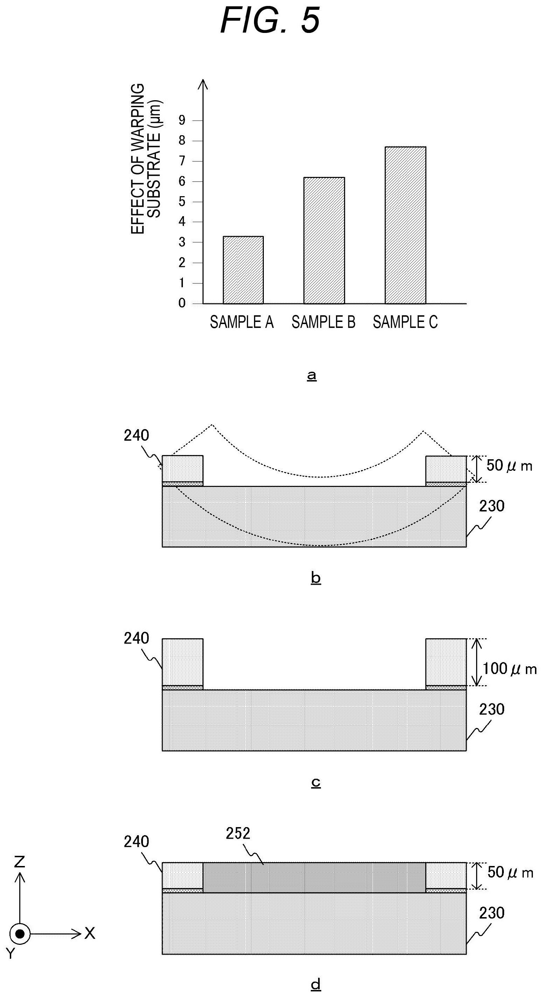

Fig. 5 is a diagram for explaining the effect of restraining warpage according to the first embodiment of the present technology. In the drawing, a illustrates the effect of each of Samples A, B, and C. In the drawing, b is a cross-sectional view of Sample A. In the drawing, c is a cross-sectional view of Sample B. In the drawing, d is a cross-sectional view of Sample C. A dotted line in b of the drawing indicates the contour of the mounting substrate 230 at the time when warpage has been generated in a manner emphasized more than it actually is.

As illustrated in b and c of the drawing, Samples A and B in which only the member 240 was bonded to the mounting substrate 230 were prepared. The thickness, which is the size in the Z-axis direction, of the member 240 of Sample A is 50 micrometers (µm). The thickness of the member 240 of Sample B is 100 micrometers (µm).

As illustrated in d of the drawing, Sample C in which the member 240 was bonded to the mounting substrate 230 and the inside thereof was filled with the underfill 252 was prepared. The thickness of the member 240 of Sample C is 50 micrometers (µm).

As illustrated in a of the drawing, the effect of restraining warpage is greater in Sample B than in Sample A, and is greater in Sample C than in Sample B. As is apparent from this result, as the thickness of the member 240 increases, the effect of correcting warpage in the smile direction increases. Furthermore, by bringing the side surface of the underfill 252 into contact with the member 240, the effect of correcting warpage in the smile direction increases in comparison with the case of not bringing the side surface into contact with the member 240.

### [Method for Manufacturing Semiconductor Package]

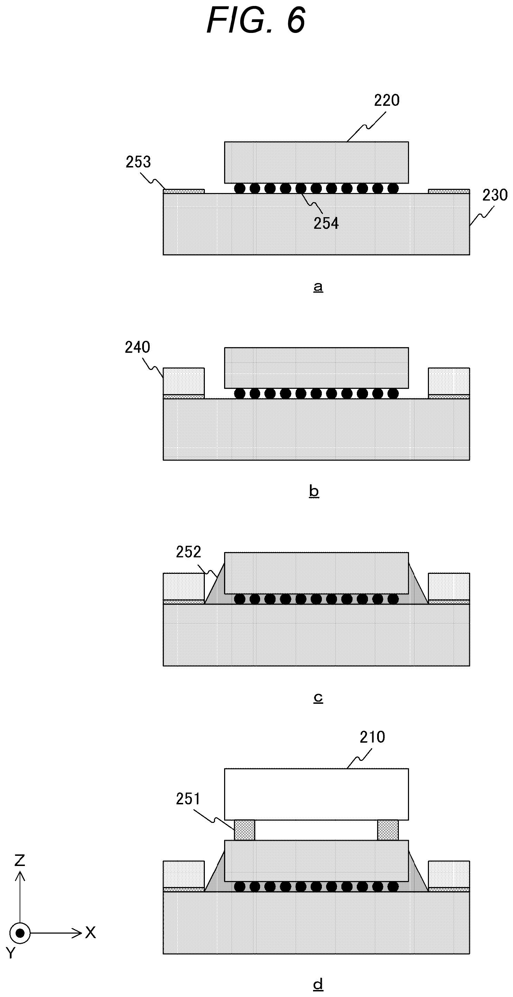

Fig. 6 is a diagram for explaining a method for manufacturing the semiconductor package 200 according to the first embodiment of the present technology. As illustrated in a of the drawing, the sensor chip 220 is placed on the mounting substrate 230, and the thermosetting adhesive 253 is applied in the periphery.

Then, as illustrated in b of the drawing, the member 240 is placed, and thermocompression bonding is performed on the member 240. Here, in a case where the glass transition temperature of the thermosetting adhesive 253 is higher than the melting temperature of solder, mounting of the sensor chip 220 by performing reflow and thermocompression bonding of the member 240 can be simultaneously performed.

In a case where reflow and thermocompression bonding are simultaneously performed, the solder balls 254 under the sensor chip 220 are not melted at the point in time of a of the drawing. Note that, in a case where reflow and thermocompression bonding are not simultaneously performed, for example, at the point in time of a of the drawing, the solder balls 254 are melted by performing reflow or the like, and the sensor chip 220 is mounted.

Then, as illustrated in c of the drawing, the underfill 252 is injected between the sensor chip 220 and the mounting substrate 230 until the side surface comes into contact with the member 240.

Then, as illustrated in d of the drawing, the resin 251 is applied to the front surface of the sensor chip 220, and the glass 210 is bonded by using the resin 251. Then, various kinds of processes in the subsequent stages are performed as necessary, and the semiconductor package 200 is completed.

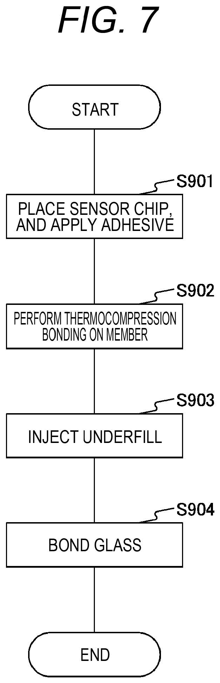

Fig. 7 is a flowchart illustrating an example of a method for manufacturing the semiconductor package 200 according to the first embodiment of the present technology.

First, the sensor chip 220 is placed on the mounting substrate 230, and the thermosetting adhesive 253 is applied in the periphery (step S901). Then, the member 240 is placed, and thermocompression bonding is performed on the member 240 (step S902). The thermocompression bonding can be performed simultaneously with reflow.

Then, the underfill 252 is injected between the sensor chip 220 and the mounting substrate 230 until the side surface comes into contact with the member 240 (step S903). Then, the resin 251 is applied to the front surface of the sensor chip 220, and the glass 210 is bonded by using the resin 251 (step S904). After step S904, various kinds of processes in the subsequent stages are performed as necessary, and a process of manufacturing the semiconductor package 200 is terminated.

As described above, according to the first embodiment of the present technology, the coefficient of thermal expansion of the member 240 is higher than that of the mounting substrate 230 and the side surface of the underfill comes into contact with the member 240, and therefore stress is generated in the smile direction. This stress enables the warpage of the sensor chip 220 to be sufficiently corrected.

### <2. Second Embodiment>

In the first embodiment described above, the sensor chip 220 is disposed in the semiconductor package 200, but performance is insufficient by only using a single chip in some cases. A semiconductor package 200 according to the second embodiment is different from that according to the first embodiment in that a chip has been added.

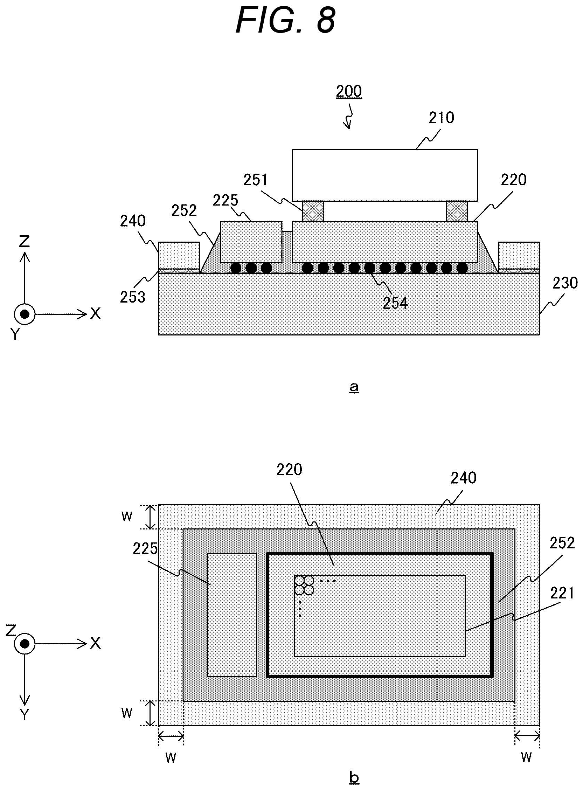

Fig. 8 illustrates examples of a cross-sectional view and a top view of the semiconductor package 200 according to the second embodiment of the present technology. In the drawing, a is the cross-sectional view of the semiconductor package 200, and b of the drawing is the top view of the semiconductor package 200. The semiconductor package 200 of the second embodiment is different from that according to the first embodiment in that an additional chip 225 is further included.

As illustrated in a and b of the drawing, the additional chip 225 is mounted on the front surface of the mounting substrate 230 to be adjacent to the sensor chip 220. The type of the additional chip 225, such as a logic chip or a memory chip, is not limited. By forming a multi-chip, as illustrated in a and b of the drawing, the performance of the semiconductor package 200 can be improved.

Furthermore, in the second embodiment, the area of the glass 210 is similar to that in the first embodiment, and the width of the member 240 is similar to that in the first embodiment.

As described above, according to the second embodiment of the present technology, the additional chip 225 is further mounted to form a multi-chip, and therefore the performance of the semiconductor package 200 can be improved.

### [Modification]

In the second embodiment described above, the additional chip 225 is further disposed, but there is a possibility that incident light will be reflected on a front surface of the additional chip 225 or a front surface of the member 240, and flare will be generated due to reflected light. A semiconductor package 200 according to a modification of the second embodiment is different from that according to the second embodiment in that respective front surfaces of the additional chip 225 and the member 240 are colored.

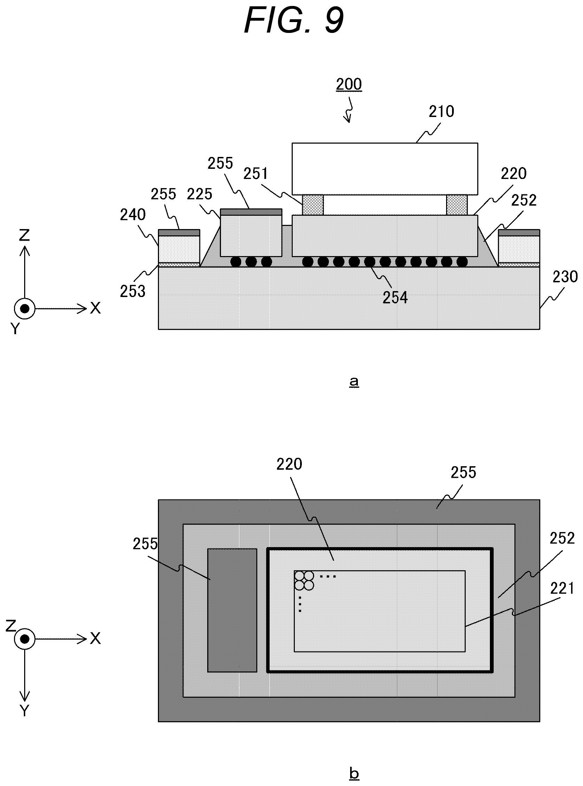

Fig. 9 illustrates examples of a cross-sectional view and a top view of the semiconductor package 200 according to the modification of the second embodiment of the present technology. In the drawing, a is the cross-sectional view of the semiconductor package 200, and b of the drawing is the top view of the semiconductor package 200.

As illustrated in a and b of the drawing, the semiconductor package 200 according to the modification of the second embodiment is different from that according to the second embodiment in that a colored resin 255 of black or the like is applied to the respective front surfaces of the additional chip 225 and the member 240. The coloring of the respective front surfaces of the additional chip 225 and the member 240 can restrain reflected light on the front surfaces thereof.

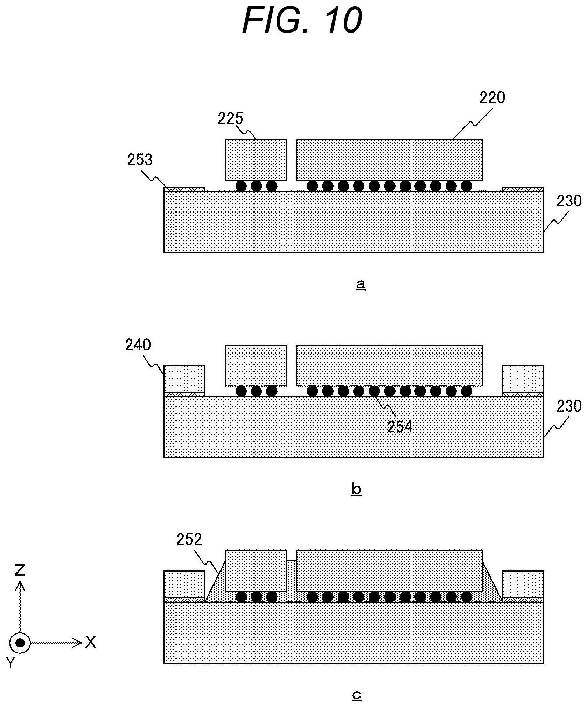

Fig. 10 is a diagram for explaining a manufacturing method up to application of the underfill 252 according to the modification of the second embodiment of the present technology. As illustrated in a of the drawing, the sensor chip 220 and the additional chip 225 are placed on the mounting substrate 230, and the thermosetting adhesive 253 is applied in the periphery.

Then, as illustrated in b of the drawing, the member 240 is placed, and thermocompression bonding is performed on the member 240. Here, in a case where the glass transition temperature of the thermosetting adhesive 253 is higher than the melting temperature of solder, mounting of the sensor chip 220 and the additional chip 225 by performing reflow and thermocompression bonding of the member 240 can be simultaneously performed.

Then, as illustrated in c of the drawing, the underfill 252 is injected between the sensor chip 220 and the additional chip 225, and the mounting substrate 230 until the side surface comes into contact with the member 240.

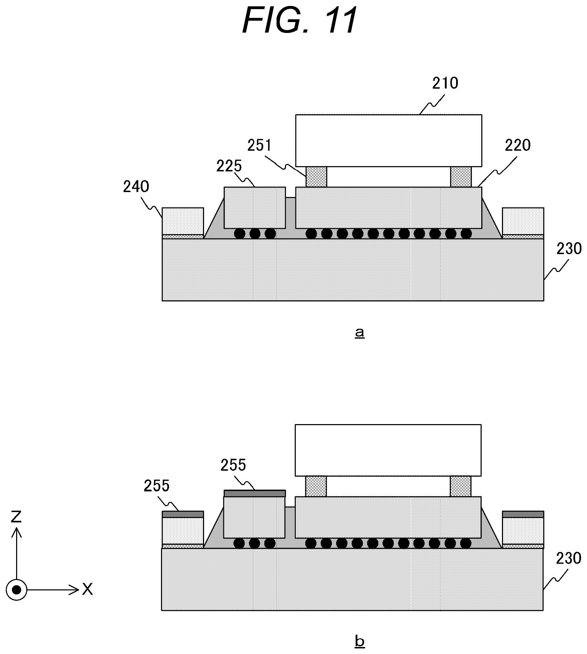

Fig. 11 is a diagram for explaining a manufacturing method up to coloring according to the modification of the second embodiment of the present technology. As illustrated in a of the drawing, the resin 251 is applied to the front surface of the sensor chip 220, and the glass 210 is bonded by using the resin 251.

Then, as illustrated in b of the drawing, the respective front surfaces of the additional chip 225 and the member 240 are colored black or the like by applying the colored resin 255.

Note that the modification of the second embodiment is applicable to the first embodiment. In the first embodiment, there is no additional chip 225, and therefore only the member 240 is colored.

As described above, according to the modification of the second embodiment of the present technology, the respective front surfaces of the additional chip 225 and the member 240 have been colored by applying the colored resin 255, and therefore reflected light can be restrained on the front surfaces thereof.

### <3. Third Embodiment>

In the second embodiment described above, the glass 210 has been bonded to the front surface of the sensor chip 220, but in this configuration, stress put on the member 240 is imbalanced between a side of the additional chip 225 without the glass 210 and a side of the sensor chip 220. A semiconductor package 200 according to a third embodiment is different from that according to the second embodiment in that the width of the member 240 on the side of the additional chip 225 is greater than that on the side of the sensor chip 220.

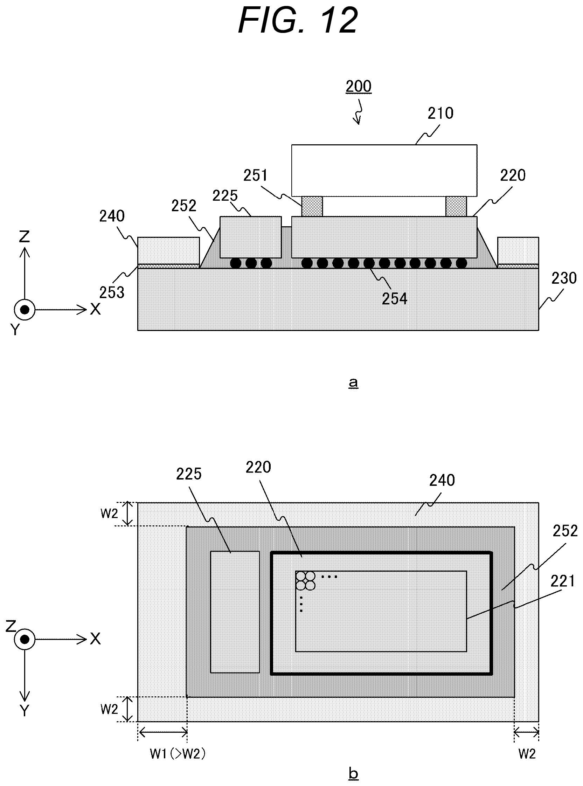

Fig. 12 illustrates examples of a cross-sectional view and a top view of the semiconductor package 200 according to the third embodiment of the present technology. In the drawing, a is the cross-sectional view of the semiconductor package 200, and b of the drawing is the top view of the semiconductor package 200.

As illustrated in b of the drawing, it is assumed that the additional chip 225 and the sensor chip 220 are arranged in the X-axis direction. In the X-axis direction, a width W1 of the member 240 on the side of the additional chip 225 is set to a value larger than that of a width W2 on the side of the sensor chip 220. A width of the member 240 in the Y-axis direction is arbitrary, and is set to, for example, W2.

By making W1 greater than W2, stress imbalance can be restrained, and peeling or cracking of the member 240 due to the imbalance can be prevented.

Note that the third embodiment is applicable to the modification of the second embodiment.

As described above, according to the third embodiment of the present technology, the width of the member 240 on the side of the additional chip 225 has been made greater than that on the side of the sensor chip 220, and therefore stress imbalance can be restrained.

### <4. Fourth Embodiment>

In the first embodiment described above, the sensor chip 220 has been mounted on a flat front surface of the mounting substrate 230, but in this configuration, the area of contact between the underfill 252 and the sensor chip 220 is insufficient in some cases. A semiconductor package 200 according to a fourth embodiment is different from that according to the first embodiment in that the mounting substrate 230 has a cavity structure.

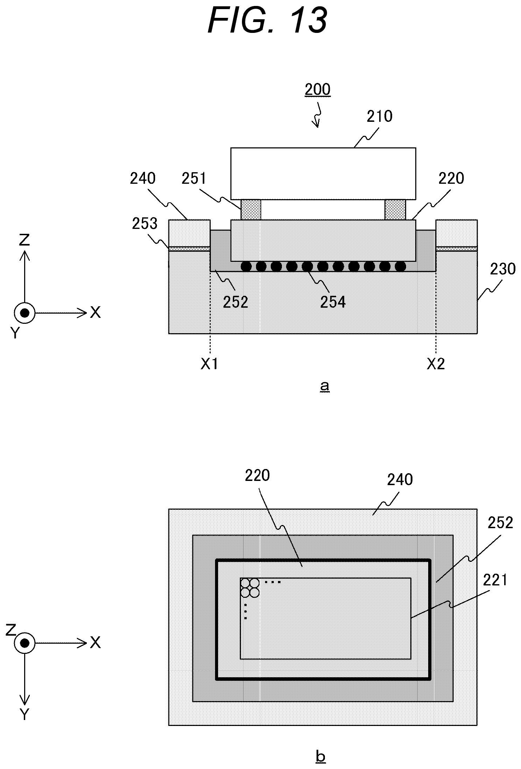

Fig. 13 illustrates examples of a cross-sectional view and a top view of a semiconductor package according to the fourth embodiment of the present technology. In the drawing, a is the cross-sectional view of the semiconductor package 200, and b of the drawing is the top view of the semiconductor package 200.

A mounting substrate 230 according to the fourth embodiment is different from that according to the first embodiment in that part of the front surface has been counterbored. For example, a portion from a coordinate X1 to a coordinate X2 in the X-axis direction is one step lower than the periphery by performing counterboring, and a space formed as a result of this machining is referred to as a "cavity". The sensor chip 220 is mounted in the cavity, and the member 240 is formed around the cavity. The underfill 252 is injected into the cavity until the side surface comes into contact with the member 240.

By providing the cavity in the mounting substrate 230 and mounting the sensor chip 220 in the cavity, the area of contact between the underfill 252 and the sensor chip 220 can be made larger than that according to the first embodiment. As a result of this, the effect of correcting the warpage of the sensor chip 220 by using the underfill 252 can be increased. Furthermore, the underfill 252 can be easily injected.

Note that the fourth embodiment is applicable to each of the second and third embodiments and the modification of the second embodiment. In this case, the additional chip 225 is further disposed in the cavity.

As described above, according to the fourth embodiment of the present technology, the sensor chip 220 is mounted in the cavity of the mounting substrate 230, and therefore the area of contact between the underfill 252 and the sensor chip 220 is increased, and the effect of correcting the warpage can be increased.

### <5. Fifth Embodiment>

In the second embodiment described above, the additional chip 225 has been further disposed, and the glass 210 has been bonded to the front surface of the sensor chip 220. However, in this configuration, stress put on the member 240 is imbalanced between the side of the additional chip 225 without the glass 210 and the side of the sensor chip 220. A semiconductor package 200 according to a fifth embodiment is different from that according to the second embodiment in that the glass 210 has been bonded to the respective front surfaces of the sensor chip 220 and the additional chip 225.

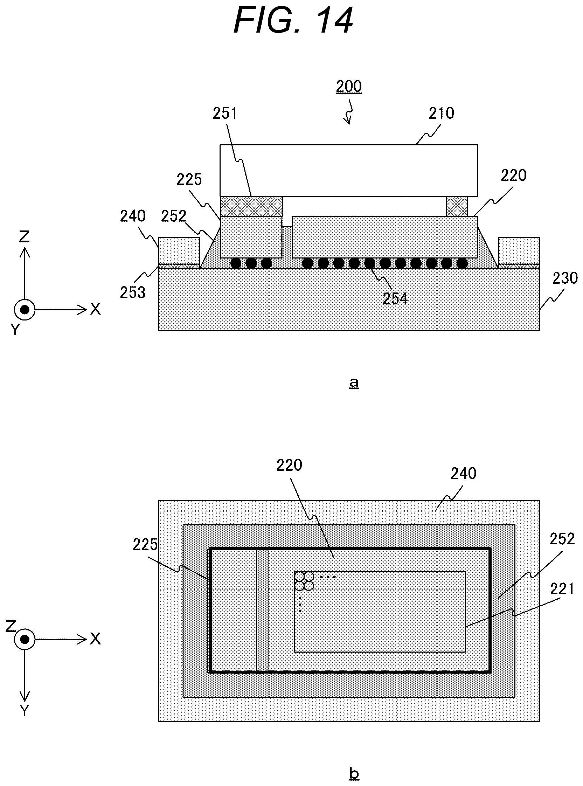

Fig. 14 illustrates examples of a cross-sectional view and a top view of a semiconductor package according to the fifth embodiment of the present technology. In the drawing, a is the cross-sectional view of the semiconductor package 200, and b of the drawing is the top view of the semiconductor package 200.

The area of the glass 210 according to the fifth embodiment is larger than that according to the second embodiment, and the glass 210 is bonded to the respective front surfaces of the sensor chip 220 and the additional chip 225 by using the resin 251. By also bonding the glass 210 to the front surface of the additional chip 225, stress on the side of the additional chip 225 can be increased, and stress imbalance can be restrained.

Note that the fifth embodiment is applicable to each of the modification of the second embodiment and the fourth embodiment.

As described above, according to the fifth embodiment of the present technology, the glass 210 has been bonded to the respective front surfaces of the sensor chip 220 and the additional chip 225, and therefore stress imbalance can be restrained.

### <6. Sixth Embodiment>

In the second embodiment described above, the shape of the member 240 is a frame shape, but is not limited to this shape. A semiconductor package 200 according to a sixth embodiment is different from that according to the second embodiment in that a discontinuous member 240 is used.

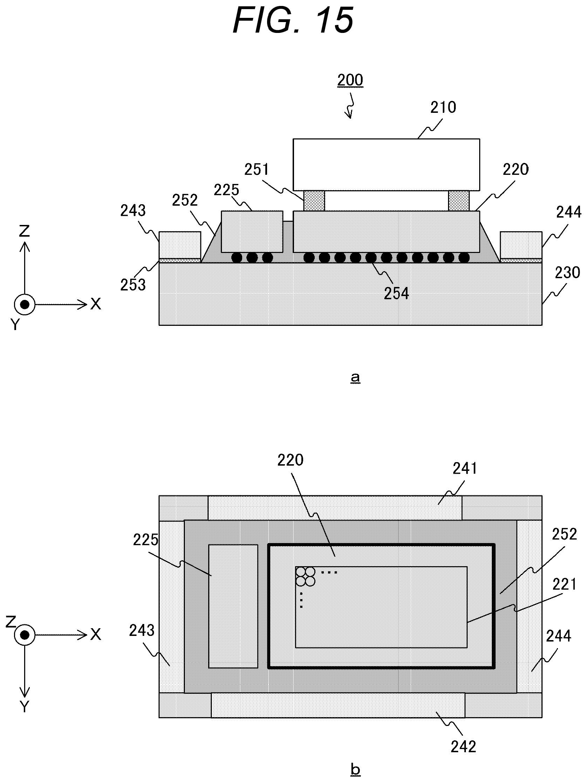

Fig. 15 illustrates examples of a cross-sectional view and a top view of a semiconductor package according to the sixth embodiment of the present technology. In the drawing, a is the cross-sectional view of the semiconductor package 200, and b of the drawing is the top view of the semiconductor package 200.

The semiconductor package 200 of the sixth embodiment is different from that according to the first embodiment in that the member 240 is discontinuous and includes a plurality of elongated plates such as plates 241 to 244. By forming these plates in a region surrounding the periphery of the sensor chip 220, the warpage of the sensor chip 220 can be corrected.

Note that the sixth embodiment is applicable to each of the second, third, fourth, and fifth embodiments and the modification of the second embodiment.

As described above, according to the sixth embodiment of the present technology, the plurality of plates has been formed in the region surrounding the periphery of the sensor chip 220, and therefore the warpage of the sensor chip 220 can be corrected.

### <7. Seventh Embodiment>

In the first embodiment described above, the member 240 has been bonded to the front surface of the mounting substrate 230, but in a case where the member 240 is conductive, wiring on the lower side thereof enables them to function as a capacitor. A semiconductor package 200 according to a seventh embodiment is different from that according to the first embodiment in that the member 240 has been bonded to wiring.

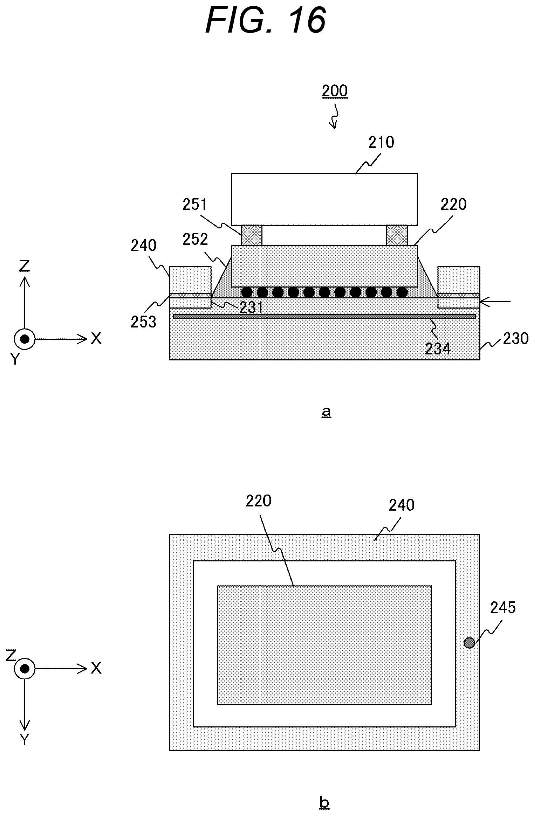

Fig. 16 illustrates examples of a cross-sectional view and a top view of a semiconductor package according to the seventh embodiment of the present technology. In the drawing, a is the cross-sectional view of the semiconductor package 200, and b of the drawing is the top view of the semiconductor package 200.

As illustrated in a of the drawing, a mounting substrate 230 according to the seventh embodiment is different from that according to the first embodiment in that wiring 231 is formed below the member 240 and a ground plane 234 is formed below the wiring 231. Furthermore, the member 240 according to the seventh embodiment is a conductive member, and is bonded to the wiring 231 by using the thermosetting adhesive 253.

As illustrated in b of the drawing, the member 240 is connected to one end of a via 245 that penetrates the thermosetting adhesive 253 and reaches the mounting substrate 230. Note that, in b of the drawing, the resin 251 and the underfill 252 are omitted.

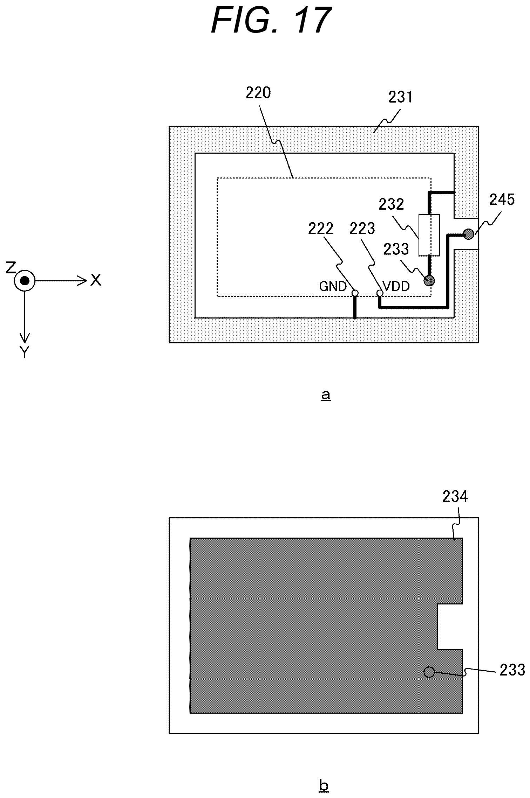

Fig. 17 illustrates an example of a cross-sectional view taken when cutting the mounting substrate 230 according to the seventh embodiment of the present technology along a plane parallel to a substrate plane. In the drawing, a is a cross-sectional view taken along an XY plane that is illustrated as an arrow in a of Fig. 16 and passes through the wiring 231, when viewed in the Z-axis direction. In the drawing, b is a cross-sectional view taken along the ground plane 234, when viewed in the Z-axis direction.

As illustrated in a of the drawing, the wiring 231 is formed along the outer periphery of the mounting substrate 230 below the member 240. However, the wiring 231 is formed to avoid a lower portion of the via 245. Furthermore, a resistance component 232 is embedded in the mounting substrate 230. One end of the resistance component 232 is connected to the wiring 231, and another end is connected to a via 233 that reaches the ground plane 234. Furthermore, the wiring 231 is connected to a ground terminal 222 of the sensor chip 220. The via 245 is connected to a power supply terminal 223 of the sensor chip 220. A dotted line in a of the drawing indicates the outer periphery of the sensor chip 220.

As illustrated in b of the drawing, the ground plane 234 is connected to the via 233. The member 240 on an upper side is connected via the via 233 to the ground plane 234. However, the ground plane 234 is not formed below the via 245.

The configuration illustrated in Figs. 16 and 17 causes the member 240 and the wiring 231 to function as a capacitor.

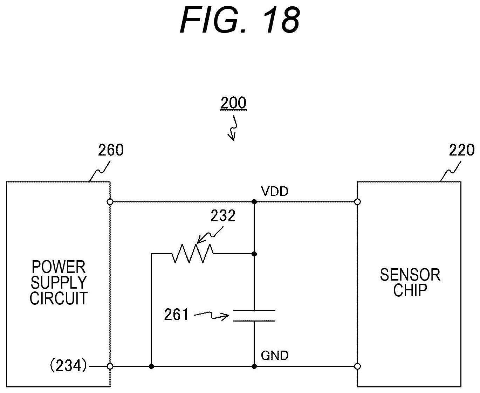

Fig. 18 is a block diagram illustrating a configuration example of the semiconductor package 200 according to the seventh embodiment of the present technology. In the semiconductor package 200, the power supply terminal and a ground terminal of the sensor chip 220 are connected to a power supply circuit 260. The power supply circuit 260 is provided in the mounting substrate 230.

The power supply circuit 260 supplies a power supply voltage VDD. Furthermore, the ground plane 234 is disposed in the power supply circuit 260. A capacitor 261 is inserted between the power supply voltage VDD and the ground plane 234. The capacitor 261 includes the member 240 and the wiring 231. Furthermore, the resistance component 232 is inserted between a connection node of the power supply voltage VDD and the capacitor 261, and the ground plane 234.

An RC filter including the capacitor 261 and the resistance component 232 can reduce noise to be transmitted from a power supply to the sensor chip 220. As a result of this, the signal quality of an image signal or the like in the sensor chip 200 can be improved.

Note that the seventh embodiment is applicable to each of the first, second, third, fourth, fifth, and sixth embodiments and the modification of the second embodiment.

As described above, according to the seventh embodiment of the present technology, the wiring 231 has been formed and the member 240 has been bonded to the wiring 231, and therefore they can be caused to function as a capacitor.

### <8. Example of Application to Mobile Body>

The technology according to the present disclosure (the present technology) can be applied to various products. For example, the technology according to the present disclosure may be implemented as a device to be mounted on any kind of mobile body such as an automobile, an electric vehicle, a hybrid electric vehicle, a motorcycle, a bicycle, a personal mobility, an airplane, a drone, a vessel, or a robot.

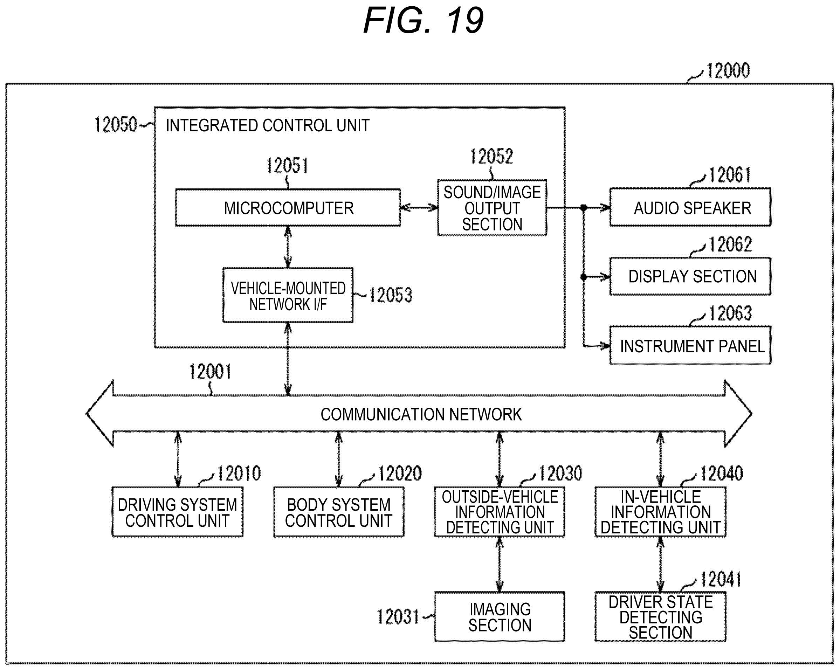

Fig. 19 is a block diagram illustrating a schematic configuration example of a vehicle control system, which is an example of a mobile body control system to which the technology according to the present disclosure is applicable.

The vehicle control system 12000 includes a plurality of electronic control units connected to each other via a communication network 12001. In the example illustrated in Fig. 19, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of Fig. 19, as the output device, an audio speaker 12061, a display section 12062, and an instrument panel 12063 are illustrated. The display section 12062 may, for example, include at least one of an on-board display and a head-up display.

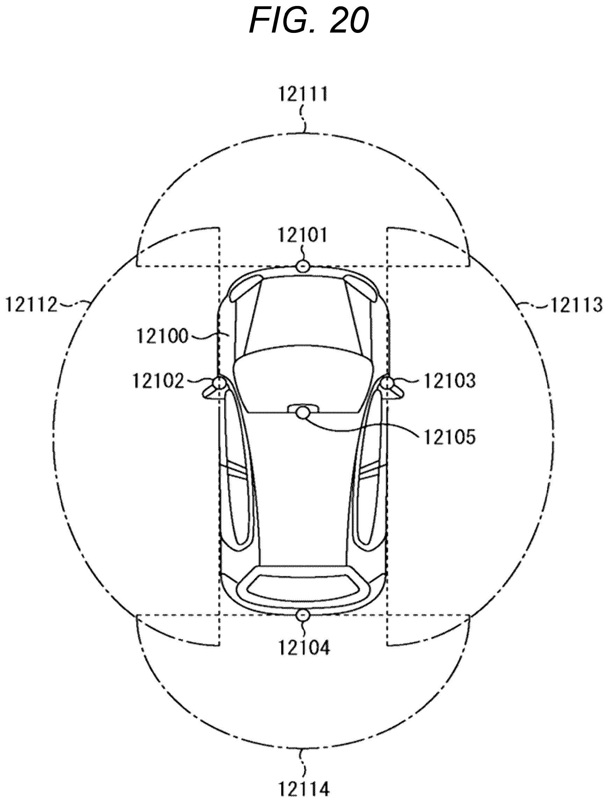

Fig. 20 is a diagram illustrating an example of the installation position of the imaging section 12031.

In Fig. 20, imaging sections 12101, 12102, 12103, 12104, and 12105 are included as the imaging section 12031.

The imaging sections 12101, 12102, 12103, 12104, and 12105 are, for example, disposed at positions on a front nose, sideview mirrors, a rear bumper, and a back door of the vehicle 12100 as well as a position on an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Note that Fig. 20 illustrates an example of imaging ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

An example of the vehicle control system to which the technology according to the present disclosure is applicable has been described above. The technology according to the present disclosure is applicable to the imaging section 12031 from among the configurations described above. Specifically, the camera module 100 of Fig. 1 is applicable to the imaging section 12031. By applying the technology according to the present disclosure to the imaging section 12031, warpage can be corrected and the reliability of the system can be improved.

Note that the embodiments described above describe examples for embodying the present technology, and the matters in the embodiments and the matters specifying the invention in the claims have respective correspondence relationships. Similarly, the matters specifying the invention in the claims and the matters with the same names in the embodiments of the present technology have respective correspondence relationships. However, the present technology is not limited to the embodiments, and can be embodied by making various modifications to the embodiments without departing from the gist of the present technology.

Furthermore, the processing procedures described in the embodiments described above may be considered as a method including a series of procedures described above, and may be considered as a program for causing a computer to perform the series of procedures or a recording medium that stores the program. As the recording medium, for example, a compact disc (CD), a mini disc (MD), a digital versatile disc (DVD), a memory card, a Blu-ray (registered trademark) disc, or the like can be used.

Note that the effects described herein are merely examples and are not restrictive, and other effects may be exhibited.

Note that the present technology can also have the following configurations.
(1) A semiconductor package including:
   a substrate;
   a semiconductor chip that is mounted on a front surface of the substrate;
   a member that is formed in a region surrounding a periphery of the semiconductor chip on the front surface of the substrate, the member having a coefficient of thermal expansion that is higher than the coefficient of thermal expansion of the substrate; and
   an underfill that is injected between the substrate and the semiconductor chip, and brings a side surface into contact with the member.
(2) The semiconductor package according to (1),
   in which the member has a frame shape when viewed in a direction perpendicular to the substrate.
(3) The semiconductor package according to (1),
   in which the member includes a plurality of elongated plates.
(4) The semiconductor package according to any of (1) to (3),
   in which the member is bonded to the front surface of the substrate by using a thermosetting adhesive having a glass transition temperature that is higher than a melting temperature of solder.
(5) The semiconductor package according to any of (1) to (4), further including
   an additional chip that is mounted on the front surface of the substrate to be adjacent to the semiconductor chip.
(6) The semiconductor package according to (5),
   in which a front surface of each of the additional chip and the member is colored.
(7) The semiconductor package according to (5) or (6), further including
   glass that is bonded to the front surface of each of the additional chip and the semiconductor chip by using resin.
(8) The semiconductor package according to (5) or (6), further including
   glass that is bonded to the front surface of the semiconductor chip by using resin.
(9) The semiconductor package according to (8),
   in which the additional chip and the semiconductor chip are arranged in a predetermined direction parallel to the substrate, and
   a width of the member in the predetermined direction is greater on a side of the additional chip than on a side of the semiconductor chip.
(10) The semiconductor package according to any of (1) to (9),
   in which a cavity is formed on the front surface of the substrate,
   the member is formed in a periphery of the cavity, and
   the semiconductor chip is mounted in the cavity.
(11) The semiconductor package according to any of (1) to (10),
   in which the substrate includes wiring formed along an outer periphery of the substrate, and
   the member includes a conductive member.
(12) The semiconductor package according to any of (1) to (11), further including
   glass,
   in which the semiconductor chip performs photoelectric conversion on incident light transmitted through the glass to generate image data.
(13) A semiconductor device including:
   a substrate;
   a semiconductor chip that is mounted on a front surface of the substrate;
   a member that is formed in a region surrounding a periphery of the semiconductor chip on the front surface of the substrate, the member having a coefficient of thermal expansion that is higher than the coefficient of thermal expansion of the substrate;
   an underfill that is injected between the substrate and the semiconductor chip, and brings a side surface into contact with the member;
   glass that is bonded to a light receiving surface of the semiconductor chip by using resin; and
   a processing circuit that performs processing on data from the semiconductor chip.
(14) A method for manufacturing a semiconductor package, the method including:
   a procedure of forming a member in a region surrounding a periphery of a semiconductor chip on a front surface of a substrate, the semiconductor chip being mounted on the front surface of the substrate, the member having a coefficient of thermal expansion that is higher than the coefficient of thermal expansion of the substrate; and
   a procedure of injecting an underfill between the substrate and the semiconductor chip until a side surface comes into contact with the member.

### REFERENCE SIGNS LIST

- 100: Camera module
- 110: Optical section
- 120: Imaging control section
- 130: DSP circuit
- 200: Semiconductor package
- 210: Glass
- 220: Sensor chip
- 221: Pixel array
- 222: Ground terminal
- 223: Power supply terminal
- 225: Additional chip
- 230: Mounting substrate
- 231: Wiring
- 232: Resistance component
- 233, 245: Via
- 234: Ground plane
- 240: Member
- 241 to 244: Plate
- 251: Resin
- 252: Underfill
- 253: Thermosetting adhesive
- 254: Solder ball
- 255: Colored resin
- 260: Power supply circuit
- 261: Capacitor
- 12031: Imaging section

## Claims

1. A semiconductor package comprising:
a substrate;
a semiconductor chip that is mounted on a front surface of the substrate;
a member that is formed in a region surrounding a periphery of the semiconductor chip on the front surface of the substrate, the member having a coefficient of thermal expansion that is higher than the coefficient of thermal expansion of the substrate; and
an underfill that is injected between the substrate and the semiconductor chip, and brings a side surface into contact with the member.

2. The semiconductor package according to claim 1,
wherein the member has a frame shape when viewed in a direction perpendicular to the substrate.

3. The semiconductor package according to claim 1,
wherein the member includes a plurality of elongated plates.

4. The semiconductor package according to claim 1,
wherein the member is bonded to the front surface of the substrate by using a thermosetting adhesive having a glass transition temperature that is higher than a melting temperature of solder.

5. The semiconductor package according to claim 1, further comprising
an additional chip that is mounted on the front surface of the substrate to be adjacent to the semiconductor chip.

6. The semiconductor package according to claim 5,
wherein a front surface of each of the additional chip and the member is colored.

7. The semiconductor package according to claim 5, further comprising
glass that is bonded to the front surface of each of the additional chip and the semiconductor chip by using resin.

8. The semiconductor package according to claim 5, further comprising
glass that is bonded to the front surface of the semiconductor chip by using resin.

9. The semiconductor package according to claim 8,
wherein the additional chip and the semiconductor chip are arranged in a predetermined direction parallel to the substrate, and
a width of the member in the predetermined direction is greater on a side of the additional chip than on a side of the semiconductor chip.

10. The semiconductor package according to claim 1,
wherein a cavity is formed on the front surface of the substrate,
the member is formed in a periphery of the cavity, and
the semiconductor chip is mounted in the cavity.

11. The semiconductor package according to claim 1,
wherein the substrate includes wiring formed along an outer periphery of the substrate, and
the member includes a conductive member.

12. The semiconductor package according to claim 1, further comprising
glass,
wherein the semiconductor chip performs photoelectric conversion on incident light transmitted through the glass to generate image data.

13. A semiconductor device comprising:
a substrate;
a semiconductor chip that is mounted on a front surface of the substrate;
a member that is formed in a region surrounding a periphery of the semiconductor chip on the front surface of the substrate, the member having a coefficient of thermal expansion that is higher than the coefficient of thermal expansion of the substrate;
an underfill that is injected between the substrate and the semiconductor chip, and brings a side surface into contact with the member;
glass that is bonded to a light receiving surface of the semiconductor chip by using resin; and
a processing circuit that performs processing on data from the semiconductor chip.

14. A method for manufacturing a semiconductor package, the method comprising:
a procedure of forming a member in a region surrounding a periphery of a semiconductor chip on a front surface of a substrate, the semiconductor chip being mounted on the front surface of the substrate, the member having a coefficient of thermal expansion that is higher than the coefficient of thermal expansion of the substrate; and
a procedure of injecting an underfill between the substrate and the semiconductor chip until a side surface comes into contact with the member.
